# EUROPÄISCHE PATENTANMELDUNG

(11) **EP 2 881 577 A1**
(43) Veröffentlichungstag der Anmeldung: **10.06.2015**
(21) Anmeldenummer: 14195401.6
(22) Anmeldetag: 28.11.2014
(51) Int. Cl.: F02M 47/02, F02M 51/06, H01L 41/04, H01L 41/053

(54) **Piezoaktor und dessen Verwendung**

(30) Priorität: 03.12.2013 DE 102013224771
(71) Anmelder: ROBERT BOSCH GMBH, 70442 Stuttgart (DE)
(72) Erfinder: Gruenberger, Andreas, 73565 Spraitbach (DE)

(57) **Zusammenfassung**

Die Erfindung betrifft ein Piezoaktor (10), insbesondere für einen Kraftstoffinjektor (100), mit zwischen einem Aktorfuß (54) und einem Aktorkopf (53) in Richtung einer Längsachse (61) übereinandergestapelten Piezoelementen (55), die bei Anlegen einer elektrischen Spannung sich in Richtung der Längsachse (61) ausdehnen, wobei der Aktorkopf (53) dazu ausgebildet ist, ein zumindest mittelbar mit dem Aktorkopf (53) verbundenes Element (52) zu betätigen, und mit einer wenigstens eine vorgespannte Zugfeder (66) aufweisenden Spanneinrichtung (65), wobei der Aktorfuß (54) axial gegen ein Gehäuseelement (16) durch die von der wenigstens einen Zugfeder (66) erzeugte Kraft anliegt. Erfindungsgemäß ist es vorgesehen, dass die wenigstens eine Zugfeder (66) den Bereich zwischen dem Aktorkopf (53) und dem Aktorfuß (54) zumindest bereichsweise radial umfasst bzw. seitlich neben dem Bereich zwischen dem Aktorkopf (53) und dem Aktorfuß (54) angeordnet ist.

## Beschreibung

### Stand der Technik

Die Erfindung betrifft einen Piezoaktor, insbesondere für einen Kraftstoffinjektor, nach dem Oberbegriff des Anspruchs 1. Ferner betrifft die Erfindung die Verwendung eines erfindungsgemäßen Piezoaktors.

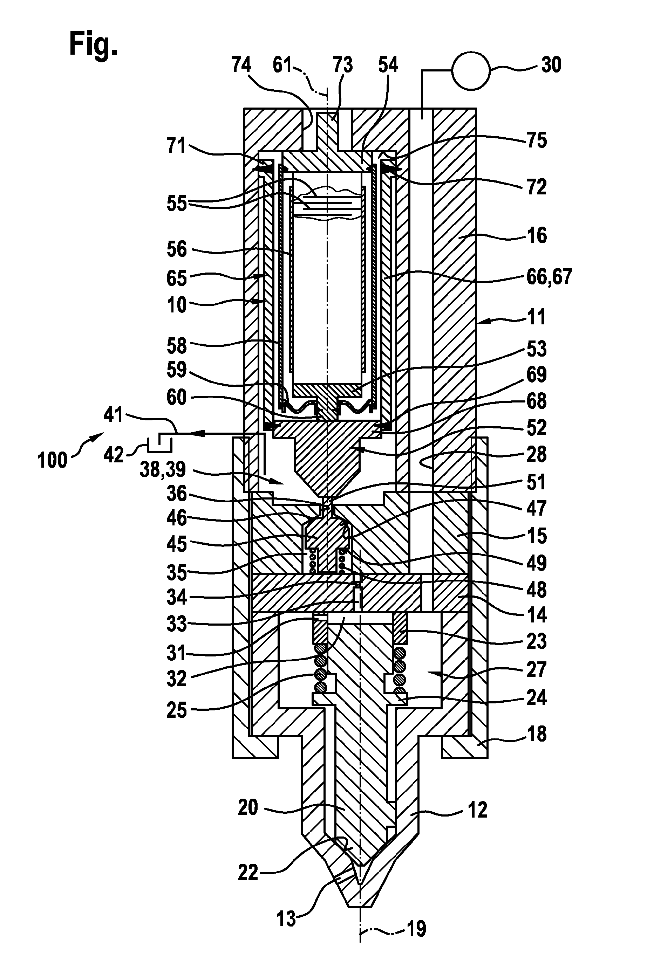

Ein Piezoaktor nach dem Oberbegriff des Anspruchs 1 ist aus der DE 199 28 186 A1 der Anmelderin bekannt. Der bekannte Piezoaktor weist eine Spanneinrichtung auf, die die Piezoelemente des Piezoaktors mit einer Zugkraft vorspannen. Dadurch wird insbesondere die Rückstellung eines mit dem Piezoaktor wirkverbunden angeordneten Elements bewirkt, um beispielsweise ein Abströmen von Kraftstoff aus einem Steuerraum bei einem Kraftstoffeinspritzventil zu verhindern. In der Fig. 2 der angesprochenen Schrift ist ein Ausführungsbeispiel dargestellt, bei dem sich der Aktorfuß des Piezoaktors in axialer Richtung gegen einen Vorsprung bzw. eine Stufe eines Gehäuseelements des Kraftstoffinjektors abstützt. Der Aktorkopf ist mittels einer Zugfeder, die auf der dem Aktorkopf gegenüberliegenden Seite des Aktorfußes an einer Befestigungseinrichtung angeordnet ist, in Richtung zum Aktorfuß hin kraftbeaufschlagt. Eine derartige Spanneinrichtung benötigt in axialer Richtung betrachtet einen relativ großen Bauraum, da sich die Zugfeder außerhalb des Piezoaktors in axialer Richtung an diesen anschließt.

### Offenbarung der Erfindung

Ausgehend von dem dargestellten Stand der Technik liegt der Erfindung die Aufgabe zugrunde, einen Piezoaktor nach dem Oberbegriff des Anspruchs 1 derart weiterzubilden, dass der in axialer Richtung benötigte Bauraum verringert ist. Diese Aufgabe wird erfindungsgemäß bei einem Piezoaktor mit den Merkmalen des Anspruchs 1 dadurch gelöst, dass die wenigstens eine Zugfeder der Spanneinrichtung den Bereich zwischen dem Aktorkopf und dem Aktorfuß zumindest bereichsweise radial umfasst bzw. seitlich neben dem Bereich zwischen dem Aktorkopf und dem Aktorfuß angeordnet ist. Mit anderen Worten gesagt bedeutet dies, dass in axialer Richtung des Piezoaktors betrachtet sich die wenigstens eine Zugfeder der Spanneinrichtung und der aus dem Aktorfuß und dem Aktorkopf sowie den zwischen dem Aktorkopf und dem Aktorfuß befindlichen Piezoelementen zumindest bereichsweise überdecken.

Vorteilhafte Weiterbildungen des erfindungsgemäßen Piezoaktors sind in den Unteransprüchen aufgeführt.

In bevorzugter konstruktiver Ausgestaltung der Erfindung ist es vorgesehen, dass die wenigstens eine Zugfeder in Form einer Zugfederhülse ausgebildet ist. Eine derartige Zugfederhülse hat gegenüber einem oder mehreren, insbesondere streifenförmigen Zugfederelementen wie beim eingangs erwähnten Stand der Technik zum Beispiel den Vorteil, dass zur Erzielung einer gewünschten Zugkraft die Zugfeder nur eine relativ geringe axiale Länge aufweisen muss.

In weiterer Ausgestaltung der Erfindung ist es vorgesehen, dass die wenigstens eine Zugfeder mit einem Kopplerkolben verbunden ist, der auf der dem Aktorfuß abgewandten Seite des Aktorkopfes angeordnet ist. Eine derartige Ausbildung bewirkt somit, dass die wenigstens eine Zugfeder bis über den Aktorkopf in Axialrichtung hinaus reicht, so dass in Bezug auf die für die Anordnung der wenigstens einen Zugfeder die gesamte Baulänge des Piezoaktors ausgenutzt wird.

In weiterer konstruktiver Ausgestaltung der Erfindung ist es vorgesehen, dass der Aktorfuß gegen eine Stirnfläche einer Ausnehmung anliegt, die in dem Gehäuseelement ausgebildet ist, und die den Piezoaktor zusammen mit der Spanneinrichtung aufnimmt.

Zur Verbindung zwischen dem Aktorkopf und der Zugfederhülse ist es von Vorteil, wenn diese Verbindung mittels einer Schweißverbindung erfolgt. Eine derartige Schweißverbindung, insbesondere als Laserstrahlschweißverbindung ausgebildet, lässt sich großserientechnisch relativ einfach realisieren und prozesstechnisch sicher überwachen und schafft die benötigte sichere bzw. feste Verbindung zwischen dem Aktorkopf und der Zugfederhülse.

Darüber hinaus ist es zur Erzielung einer möglichst hohen bzw. gleichmäßigen Zugkraft von Vorteil, wenn die wenigstens eine Zugfeder in Richtung der Längsachse des Piezoaktors betrachtet eine Länge aufweist, die zumindest der Höhe der übereinander gestapelten Piezoelemente entspricht.

Weiterhin kann es vorgesehen sein, dass die Verbindung zwischen der Zugfederhülse und dem zweiten Gehäuseelement ebenfalls mittels einer Schweißverbindung erfolgt. Auch diese Verbindung lässt sich im großserientechnischen Einsatz relativ einfach verwirklichen bzw. realisieren.

Insbesondere kann es vorgesehen sein, dass das Gehäuseelement ein Haltekörper ist, der Bestandteil eines Gehäuses oder in ein Gehäuse einsetzbar ist. Die zuletzt genannte Variante hat insbesondere den Vorteil, dass der Piezoaktor zusammen mit dem Haltekörper als vormontierbare Baueinheit ausgebildet werden kann, die bei der Montage des Kraftstoffinjektors relativ einfach in das Injektorgehäuse eingesetzt werden kann.

Ein besonders robuster Piezoaktor lässt sich dadurch erzielen, wenn die Piezoelemente, vorzugsweise zusammen mit dem Aktorfuß und dem Aktorkopf, innerhalb eines mediendichten Schutzgehäuses angeordnet sind.

Bevorzugt ist die Verwendung eines derartigen, erfindungsgemäßen Piezoaktors als Bestandteil eines Kraftstoffinjektors bei selbstzündenden Brennkraftmaschinen.

Weitere Vorteile, Merkmale und Einzelheiten der Erfindung ergeben sich aus der nachfolgenden Beschreibung bevorzugter Ausführungsbeispiele sowie anhand der Zeichnung.

Diese zeigt in der einzigen Figur ein Ausführungsbeispiel eines erfindungsgemäßen Piezoaktors in einem vereinfachten Längsschnitt.

Der in der einzigen Figur dargestellte Piezoaktor 10 ist Teil eines Kraftstoffinjektors 100, wie er insbesondere als Bestandteil eines sogenannten Common-Rail-Einspritzsystems bei selbstzündenden Brennkraftmaschinen zum Einspritzen von Kraftstoff in den Brennraum der Brennkraftmaschine verwendet wird.

Der Kraftstoffinjektor 100 hat ein mehrteilig ausgebildetes Gehäuse 11, das einen Düsenkörper 12 aufweist. In dem Düsenkörper 12 ist auf der dem Brennraum zugewandten Seite wenigstens eine Einspritzöffnung 13 zum Einspritzen des Kraftstoffs in den angesprochenen Brennraum ausgebildet. Auf der der Einspritzöffnung 12 abgewandten Seite des Düsenkörpers 12 schließt sich in axialer Richtung des Gehäuses 11 betrachtet eine Drosselplatte 14 und eine Ventilplatte 15 sowie ein Haltekörper 16 an. Der Düsenkörper 12 ist unter axialer Zwischenlage der Drosselplatte 14 und der Ventilplatte 15 mittels einer Überwurfmutter 18 in bekannter Art und Weise axial gegen den Haltekörper 16 verspannt.

In dem Düsenkörper 12 ist entlang einer Längsachse 19 eine als Einspritzglied dienende Düsennadel 20 axialbeweglich angeordnet. Die Düsennadel 20 dichtet in der in der Figur dargestellten abgesenkten Stellung der Düsennadel 20 die wenigstens eine Einspritzöffnung 13 ab, wobei zwischen der Düsennadel 20 und dem Düsenkörper 12 ein Dichtsitz 22 ausgebildet ist. Zum Einspritzen von Kraftstoff in den nicht gezeigten Brennraum der Brennkraftmaschine hebt die Düsennadel 20 von dem Dichtsitz 22 ab. Die Düsennadel 20 ragt mit ihrem der wenigstens einen Einspritzöffnung 13 abgewandten Endbereich axial in eine Steuerraumhülse 23 hinein, die sich mit ihrer einen Stirnseite an der Unterseite der ihr zugewandten Drosselplatte 14 abstützt. An der Düsennadel 20 ist ein radial umlaufender Bund 24 ausgebildet, gegen den sich eine als Schließelement dienende Druckfeder 25 abstützt, die mit ihrem dem Bund 24 abgewandten Ende sich gegen die andere der Drosselplatte 14 abgewandte Stirnfläche der Steuerraumhülse 23 abstützt.

Von dem Düsenkörper 12 und der Drosselplatte 14 ist ein Hochdruckraum 27 begrenzt, der über wenigstens eine, in der Drosselplatte 14, der Ventilplatte 15 sowie dem Haltekörper 16 ausgebildete Versorgungsbohrung 28 mit unter Hochdruck stehendem Kraftstoff aus einem Kraftstoffspeicher 30 (Rail) versorgt wird. Von der Steuerraumhülse 23, der Düsennadel 20 sowie der Drosselplatte 14 ist ein Steuerraum 32 begrenzt, der über eine in der Steuerraumhülse 23 ausgebildete Zulaufbohrung 31 mit dem Hochdruckraum 27 verbunden ist. Der Steuerraum 32 ist darüber hinaus über eine in der Drosselplatte 14 ausgebildete Ablaufbohrung 33 mit in der Ablaufbohrung 33 intrigierter Ablaufdrossel 34 mit einem in der Ventilplatte 15 ausgebildeten Ventilsteuerraum 35 hydraulisch verbunden. Der Ventilsteuerraum 35 ist wiederum über eine Durchgangsbohrung 36 mit einer in dem Haltekörper 16 ausgebildeten Ausnehmung 38 verbunden, die einen Niederdruckbereich 39 des Gehäuses 11 ausbildet. Der Niederdruckbereich 39 ist über eine Rücklaufleitung 41 beispielsweise mit dem Tank 42 des Kraftfahrzeugs gekoppelt.

Innerhalb des Ventilsteuerraums 35 ist ein Schließglied 45 angeordnet, das dazu dient, einen Kraftstofffluss von dem Ventilsteuerraum 35 in den Niederdruckbereich 39 durch die Durchgangsbohrung 36 zu steuern. Hierzu weist das Schließglied 45 eine radial umlaufende Dichtkante 46 auf, die in der in der Figur dargestellten angehobenen Stellung unter Ausbildung eines Dichtsitzes an einer kegelförmig umlaufenden Dichtfläche 47 des Ventilsteuerraums 35 anliegt. Hierzu dient eine Schließfeder 48, die sich zwischen einer an dem Schließglied 45 ausgebildeten Stufe 49 und der dem Schließglied 45 zugewandten Stirnfläche der Drosselplatte 14 axial abstützt.

Das Schließglied 45 weist einen zapfenförmigen Fortsatz 51 auf, der mit radialem Spiel durch die Durchgangsbohrung 36 hindurchragt und mit einem Abschnitt bis in den Niederdruckbereich 39 reicht. Um das Schließglied 45 von der in der Figur dargestellten Schließposition in eine Position zu bewegen, bei der Kraftstoff aus dem Ventilsteuerraum 35 über die Durchgangsbohrung 36 in den Niederdruckbereich 39 gelangt, ist es erforderlich, das Schließglied 45 über den Fortsatz 51 entgegen der Federkraft der als Druckfeder ausgebildeten Schließfeder 48 zu bewegen. Hierzu dient ein innerhalb der Ausnehmung 38 angeordneter Kopplerkolben 52, der Bestandteil des Piezoaktors 10 ist.

Der Piezoaktor 10 umfasst darüber hinaus auf der dem Kopplerkolben 52 zugewandten Seite einen Aktorkopf 53, der mit dem Kopplerkolben 52 wirkverbunden angeordnet ist, sowie einen Aktorfuß 54. Zwischen dem Aktorkopf 53 und dem Aktorfuß 54 sind eine Vielzahl, von im Einzelnen nicht dargestellten Piezoelementen 55 übereinandergestapelt angeordnet. Die Piezoelemente 55 sind wiederum in an sich bekannter Art und Weise radial von einer Schutzschicht 56 umgeben, die vorzugsweise elastische Eigenschaften aufweist. Darüber hinaus sind die Piezoelemente 55 mit radialem Abstand von einer mediendichten Schutzhülse 58 umgeben, die einerseits mit dem Aktorfuß 54 starr verbunden ist, und die andererseits über ein elastisches Dichtelement 59, das im Wesentlichen ringförmig ausgebildet ist, an einem Fortsatz 60 des Aktorkopfes 53 gekoppelt, der in Anlagekontakt mit dem Kopplerkolben 52 ist.

Zur Betätigung des Schließglieds 45 durch den Kopplerkolben 52 werden die Piezoelemente 55 mit einer nicht dargestellten Spannungsquelle verbunden, was zu einer Ausdehnung der Piezoelemente 55 in Richtung der Längsachse 61 des Piezoaktors 10 führt. Die Ausdehnung der Piezoelemente 55 wird über den Aktorkopf 53 und den über den mit dem Aktorkopf 53 wirkverbunden angeordneten Kopplerkolben 52 in eine entsprechende Längsbewegung des Schließelements 45 umgesetzt.

Um bei einer elektrischen Trennung der Piezoelemente 55 von der Spannungsquelle eine möglichst schnelle und vollständige Rückführung der Piezoelemente 55 in ihre ursprüngliche, nicht ausgedehnte Position zu ermöglichen, weist der Piezoaktor 60 darüber hinaus eine Spanneinrichtung 65 auf. Die Spanneinrichtung 65 umfasst eine Zugfeder 66 in Form einer radial umlaufenden Zugfederhülse 67, die sich in axialer Richtung von der Höhe des Aktorfußes 54 über alle Piezoelemente 55 und den Aktorkopf 53 bis in Höhe des Kopplerkolbens 52 erstreckt. Dort ist die Zugfederhülse 67 mit einem radial umlaufenden Flansch 68 des Kopplerkolbens 52 über eine ebenfalls radial umlaufende Schweißverbindung 69, die insbesondere als Laserschweißverbindung ausgebildet ist, verbunden. In etwa in Höhe des Aktorfußes 54 ist die Zugfederhülse 67 an einem radial umlaufenden Halteflansch 71 mit der Ausnehmung 38 in dem Haltekörper 16 verbunden, vorzugsweise ebenfalls durch eine radial umlaufende Schweißverbindung 72.

Die Zugfederhülse 67 umgibt die Piezoelemente 55 bzw. den Aktorkopf 53 und den Aktorfuß 54 mit radialem Abstand und ist konzentrisch zur Längsachse 61 des Piezoaktors 10 angeordnet. Wesentlich ist, dass der Aktorfuß 54, der einen stiftförmigen Fortsatz 73 aufweist, der mit radialem Abstand in eine in dem Haltekörper 16 ausgebildete, von der Ausnehmung 38 ausgehende Durchgangsbohrung 74 hineinragt, axial gegen den eine Stirnfläche der Ausnehmung 38 bildenden Grund 75 der Ausnehmung 38 im Übergangsbereich zur Durchgangsbohrung 74 anliegt. Die axiale Anlage des Aktorfußes 54 gegen den Grund 75 wird durch die Spanneinrichtung 65 bewirkt, die den Piezoaktor 10 bzw. die Piezoelemente 55, den Aktorkopf 53 und den Aktorfuß 54 über den Kopplerkolben 52 und die Zugfederhülse 67 gegen den Grund 75 kraftbeaufschlagt. Eine derartige Ausbildung der Spanneinrichtung 65 bewirkt insbesondere, dass selbst beim schnellen Schalten des Piezoaktors 10 der Aktorfuß 54 stets in Anlage mit dem Grund 75 der Ausnehmung 38 im Haltekörper 16 angeordnet ist.

Der soweit beschriebene Piezoaktor 10 bzw. der Kraftstoffinjektor 100 können auf vielfältige Art und Weise abgewandelt bzw. modifiziert werden, ohne vom Erfindungsgedanken abzuweichen.

## Patentansprüche

1. Piezoaktor (10), insbesondere für einen Kraftstoffinjektor (100), mit zwischen einem Aktorfuß (54) und einem Aktorkopf (53) in Richtung einer Längsachse (61) übereinandergestapelten Piezoelementen (55), die sich bei Anlegen einer elektrischen Spannung in Richtung der Längsachse (61) ausdehnen, wobei der Aktorkopf (53) dazu ausgebildet ist, ein zumindest mittelbar mit dem Aktorkopf (53) verbundenes Element (52) zu betätigen, und mit einer wenigstens eine vorgespannte Zugfeder (66) aufweisenden Spanneinrichtung (65), wobei der Aktorfuß (54) axial gegen ein Gehäuseelement (16) durch die von der wenigstens einen Zugfeder (66) erzeugte Kraft anliegt,
**dadurch gekennzeichnet,**
**dass** die wenigstens eine Zugfeder (66) den Bereich zwischen dem Aktorkopf (53) und dem Aktorfuß (54) zumindest bereichsweise radial umfasst bzw. seitlich neben dem Bereich zwischen dem Aktorkopf (53) und dem Aktorfuß (54) angeordnet ist.

2. Piezoaktor nach Anspruch 1,
**dadurch gekennzeichnet,**
**dass** die wenigstens eine Zugfeder (66) in Form einer Zugfederhülse (67) ausgebildet ist.

3. Piezoaktor nach Anspruch 1 oder 2,
**dadurch gekennzeichnet,**
**dass** die Zugfeder (66) einerseits zumindest mittelbar mit dem Aktorkopf (53) und andererseits mit dem Gehäuseelement (16) verbunden ist,

4. Piezoaktor nach einem der Ansprüche 1 bis 3,
**dadurch gekennzeichnet,**
**dass** die wenigstens eine Zugfeder (66) mit dem als Kopplerkolben ausgebildeten Element (52) verbunden ist, das auf der dem Aktorfuß (54) abgewandten Seite des Aktorkopfes (53) angeordnet ist.

5. Piezoaktor nach einem der Ansprüche 1 bis 4,
**dadurch gekennzeichnet,**
**dass** der Aktorfuß (54) gegen eine Stirnfläche (75) einer Ausnehmung (38) anliegt, die in dem Gehäuseelement (16) ausgebildet ist, und die den Piezoaktor (10) zusammen mit der Spanneinrichtung (65) aufnimmt.

6. Piezoaktor nach einem der Ansprüche 2 bis 5,
**dadurch gekennzeichnet,**
**dass** die Verbindung zumindest zwischen dem Aktorkopf (53) und der Zugfederhülse (67) mittels einer Schweißverbindung (69) erfolgt.

7. Piezoaktor nach einem der Ansprüche 1 bis 6,
**dadurch gekennzeichnet,**
**dass** die wenigstens eine Zugfeder (66) in Richtung der Längsachse (61) betrachtet eine Länge aufweist, die zumindest der Höhe der übereinandergestapelten Piezoelemente (55) entspricht.

8. Piezoaktor nach einem der Ansprüche 3 bis 7,
**dadurch gekennzeichnet,**
**dass** die Verbindung zwischen der Zugfederhülse (67) und dem Gehäuseelement (16) mittels einer Schweißverbindung (72) erfolgt.

9. Piezoaktor nach einem der Ansprüche 1 bis 8,
**dadurch gekennzeichnet,**
**dass** das Gehäuseelement (16) ein Haltekörper ist, der Bestandteil eines Gehäuses (11) oder in ein Gehäuse (11) einsetzbar ist.

10. Piezoaktor nach einem der Ansprüche 1 bis 9,
**dadurch gekennzeichnet,**
**dass** die Piezoelemente (55), vorzugsweise zusammen mit dem Aktorfuß (54) und dem Aktorkopf (53), innerhalb eines mediendichten Schutzgehäuses (58) angeordnet sind.

11. Verwendung eines Piezoaktor (10) nach einem der Ansprüche 1 bis 10 als Bestandteil eines Kraftstoffinjektors (100) bei selbstzündenden Brennkraftmaschinen.
